(19) Europäisches Patentamt
European Patent Office
Office européen des brevets

(11) **EP 2 390 678 B1**

(12) **EUROPÄISCHE PATENTSCHRIFT**

(45) Veröffentlichungstag und Bekanntmachung des Hinweises auf die Patenterteilung:
**26.06.2013 Patentblatt 2013/26**

(51) Int Cl.:
*G01R 35/00* (2006.01)    *G01R 19/165* (2006.01)
*H05B 33/08* (2006.01)    *B60Q 11/00* (2006.01)

(21) Anmeldenummer: **10164046.4**

(22) Anmeldetag: **27.05.2010**

(54) **Ausfallerkennung bei parallel geschalteten Verbrauchern**

Device for detecting failure of loads connected in parallel

Reconnaissance de panne dans des consommateurs couplés en parallèle

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**30.11.2011 Patentblatt 2011/48**

(73) Patentinhaber: **Hella KGaA Hueck & Co.**
**59552 Lippstadt (DE)**

(72) Erfinder: **Fortkort, Karl-Heinz**
**59329 Wadersloh (DE)**

(56) Entgegenhaltungen:
**EP-A1- 1 903 836    EP-A2- 1 000 806**
**DE-A1- 10 107 578    DE-U1-202007 007 776**
**US-B1- 7 363 186**

EP 2 390 678 B1

**Beschreibung**

GEBIET DER ERFINDUNG

Die vorliegende Erfindung betrifft eine Schaltungsanordnung in einem Steuergerät, insbesondere für Beleuchtungsvorrichtungen. Im Genaueren betrifft die vorliegende Erfindung eine Ausfallerkennung eines Verbrauchers bei mehreren parallel geschalteten Verbrauchern, insbesondere von Leuchtmitteln, wie LED's, in Leuchtmittelvorrichtungen. Die vorliegende Erfindung findet Anwendung in Beleuchtungsvorrichtungen für Kraftfahrzeuge und im allgemeinen in Beleuchtungsvorrichtungen mit parallel geschalteten Verbrauchern.

HINTERGRUND DER ERFINDUNG

Parallel geschaltete Verbraucher, wie beispielsweise Leuchtdioden oder Glühlampen, werden als Beleuchtung in einem Kraftfahrzeug in der Regel durch Halbleiterschaltereinrichtungen angesteuert und mit einem Laststrom versorgt. Diese Halbleiterschaltereinrichtungen bieten die Möglichkeit, durch einen an der Halbleiterschaltereinrichtung bereitgestellten Diagnoseausgang den Laststrom am Laststromausgang der Halbleiterschaltereinrichtung zu messen. Der durch den Diagnoseausgang ausgegebene Diagnosestrom ist proportional zu dem durch den Laststromausgang der Halbleiterschaltereinrichtung ausgegebenen Laststrom. Die Proportionalität des Laststroms zu dem Diagnosestrom ist durch einen Übertragungsfaktor (K-Faktor) gegeben und wird vom Hersteller der Halbleiterschaltereinrichtung angegeben. Der tatsächliche K-Faktor kann sich in dem vom Hersteller angegebenen Bereich um bis zu 200% bis 300% unterscheiden. Der K-Faktor ist neben den Herstellungstoleranzen von dem Laststrom am Laststromausgang und von der Temperatur der Halbleiterschaltereinrichtung abhängig.

Grundsätzlich sind parallel geschaltete Verbraucher und entsprechende Schaltungsanordnungen zum Beispiel aus der US 7, 363, 186 B1 oder der DE 20 2007 007 776 U1 bekannt. Dort sind zum Beispiel Verfahren und Apparate dargestellt, die zur Selbstkalibrierung eines Stromfeedbacks ausgelegt sind. Diese sind zum Beispiel als Anhängeranschlussgerät implementiert.

ZUSAMMENFASSUNG DER ERFINDUNG

Aufgrund der herstellungsbedingten Variation von bis zu 200% bis 300% des K-Faktors ist es mit Schaltungsanordnungen gemäß dem Stand der Technik unter Verwendung des von der Halbleiterschaltereinrichtung bereitgestellten Diagnosestroms nicht möglich, bei parallel verbundenen Verbrauchern, die von der Halbleiterschaltereinrichtung mit einem Laststrom versorgt werden, eine Unterscheidung zwischen einer Last von beispielsweise 50 mA und zwei parallelen Lasten von entsprechend 100 mA durchzuführen. Durch die große Ungenauigkeit der Herstellerangabe bezüglich des K-Faktors ist die Bestimmung des Laststroms am Laststromausgang der Halbleiterschaltereinrichtung mittels einem dem Laststrom proportionalen Diagnosestrom nicht möglich, da ein entsprechend erhaltener Wert für den Laststrom aufgrund der Ungenauigkeit des K-Faktors die gleiche Ungenauigkeit wie der K-Faktor von bis zu 200% bis 300% aufweist. Folglich ist es mit Schaltungsanordnungen gemäß dem Stand der Technik unter Verwendung des von der Halbleiterschaltereinrichtung bereitgestellten Diagnosestroms nicht möglich, bei zwei parallel geschalteten Verbrauchern den Ausfall eines der Verbraucher verlässlich zu bestimmen.

Eine Einzelausfallerkennung von Leuchtdioden wird bisher bei Karosserieelektronikmodulen (BCM; Abkürzung für "Body Control Module" aus dem Englischen) nur selten durchgeführt, da ein erheblicher zusätzlicher Hardwareaufwand zur genauen Messung des Laststroms am Laststromausgang der Halbleiterschaltereinrichtung erforderlich ist. Durch einen Messwiderstand am Drain-Anschluss der Halbleiterschaltereinrichtung und mit Hilfe eines integrierten Schaltkreises (IC) zur Spannungswandlung kann eine Einzelausfallerkennung realisiert werden. Die hierzu erforderlichen zusätzlichen Bauteile, die höhere Verlustleistung und der zusätzlich benötigte Platzbedarf führen zu einer wesentlichen Kostenerhöhung des Lastpfades.

Eine Aufgabe der vorliegenden Erfindung ist die zuverlässige, kostengünstige und mit lediglich einer kleinen Verlustleistung behaftete Bestimmung des Ausfalls eines

Verbrauchers bei parallel geschalteten Verbrauchern, die mit einem Laststrom von einer Halbleiterschaltervorrichtung versorgt werden.

Diese Aufgabe wird dadurch gelöst, dass dem Laststrom am Laststromausgang der Halbleiterschaltervorrichtung ein zusätzlicher vordefinierter Stromimpuls aufgeprägt wird.

Im genaueren wird die Aufgabe durch eine Schaltungsanordnung in einem Steuergerät zur Steuerung von parallel geschalteten Verbrauchern gemäß den Merkmalen des unabhängigen Patentanspruchs 1 sowie durch ein Verfahren zur Einzelausfallerkennung eines Verbrauchers bei parallel geschalteten Verbrauchern gemäß den Merkmalen des unabhängigen Patentanspruchs 8 gelöst. Weitere Merkmale und Details der Erfindung ergeben sich aus den Unteransprüchen, der Beschreibung und den Zeichnungen. Dabei gelten Merkmale und Details, die in Zusammenhang mit der erfinderischen Schaltungsanordnung beschrieben sind, selbstverständlich auch in Zusammenhang mit dem erfindungsgemäßen Verfahren und umgekehrt, so dass bezüglich der Offenbarung zu den einzelnen Erfindungsaspekten stets wechselseitig Bezug genommen werden kann.

Gemäß einem ersten Aspekt der vorliegenden Erfindung umfasst eine Schaltungsanordnung in einem Steuergerät zur Steuerung von parallel geschalteten Verbrauchern, wie beispielsweise Leuchtmitteln, eine Halbleiterschaltereinrichtung, die wiederum beispielsweise einen MOSFET Transistor umfassen kann. Die Halbleiterschaltereinrichtung umfasst einen Laststromausgang zum Zuführen eines Laststroms zu den Verbrauchern und umfasst ferner einen Diagnosestromausgang bzw. einen Sensestromausgang zum Ausgeben eines Diagnosestroms bzw. Sensestroms, der proportional zu einem am Laststromausgang fließenden Strom ist. Die Proportionalität zwischen dem Laststrom und dem Diagnosestrom ist durch einen Übertragungsfaktor gegeben, der der Quotient aus Laststrom und Diagnosestrom ist. Folglich kann mit bekanntem Übertragungsfaktor der am Laststromausgang der Halbleiterschaltereinrichtung fließende Strom bestimmt werden durch Messen bzw. Ausgeben des Diagnosestroms. Ein Unterschreiten eines Grenzwerts des Laststroms lässt den Rückschluss auf einen Ausfall eines Verbrauchers der parallel geschalteten Verbraucher zu. Zur Bestimmung des Grenzwerts ist eine genaue Kenntnis des Übertragungsfaktors notwendig.

Das Steuergerät ist daher zum Bestimmen eines Grenzwerts für den ermittelten Laststrom bzw. für den detektierten Diagnosestrom ausgebildet. Da der Übertragungsfaktor aufgrund des Herstellungsprozesses eine Ungenauigkeit von bis zu 200% bis 300% aufweist, ist es zum zuverlässigen und genauen Bestimmen eines Grenzwerts für den detektierten Laststrom notwendig, den Übertragungsfaktor genügend genau zu bestimmen. Zur Bestimmung des Grenzwerts ist das Steuergerät daher ausgebildet zum Erzeugen eines vordefinierten Stromimpulses, der dem Laststrom am Laststromausgang der Halbleitschaltereinrichtung aufprägbar ist. Weiterhin ist das Steuergerät zum Bestimmen des Übertragungsfaktors basierend auf dem Laststrom und dem vordefinierten Stromimpuls, zum Ermitteln des Grenzwerts basierend auf dem Übertragungsfaktor und dem Laststrom und zum Ermitteln eines Diagnosestromgrenzwerts basierend auf einem vordefinierten Laststromgrenzwert und dem Übertragungsfaktor ausgebildet. Das Steuergerät kann in Abhängigkeit eines Vergleichs des detektierten Diagnosestroms mit dem ermittelten Grenzwert und dem Diagnosestromgrenzwert ein Verbraucherausfallsignal ausgeben. Dieses Verbraucherausfallsignal kann beispielsweise ein elektrisches, ein optisches oder ein akustisches Signal sein.

Zum Erzeugen des vordefinierten Stromimpulses kann die Schaltungsanordnung ferner einen Halbleiterschalter umfassen. Der Halbleiterschalter umfasst wiederum einen Impulssteuerungseingang zum Empfangen eines Steuerungssignals vom Steuergerät, um den Halbleiterschalter zu schalten. Weiterhin umfasst der Halbleiterschalter einen Stromeingang, der mit dem Laststromausgang der Halbleiterschaltereinrichtung über einen Widerstand verbunden ist. Durch Einschalten des Halbleiterschalters durch ein Steuerungssignal vom Steuergerät kann parallel zu den Verbrauchern somit eine weitere, bekannte Last angelegt werden. Dem am Laststromausgang der Halbleiterschaltereinrichtung fließenden Laststrom ist somit ein bekannter bzw. vordefinierter Stromimpuls aufprägbar.

Zum Bestimmen des Grenzwerts für den ermittelten detektierten Diagnosestrom, der proportional zu dem Laststrom am Laststromausgang der Halbleiterschaltereinrichtung ist, kann das Steuergerät ferner zum Ermitteln der Zufuhr eines Laststroms zu den Verbrauchern ausgebildet sein. Das Steuergerät kann folglich ermitteln, ob den Verbrauchern durch die Halbleiterschaltereinrichtung ein Laststrom zugeführt wird.

Ferner kann das Steuergerät ausgebildet sein zum Ermitteln eines ersten Diagnosestroms, der proportional zu dem Laststrom ist und von der Halbleiterschaltereinrichtung ausgebbar ist, in Abhängigkeit des den Verbrauchern zugeführten Laststroms. Folglich kann durch das Steuergerät ein erster Diagnosestrom ermittelt werden, wenn den Verbrauchern durch die Halbleiterschaltereinrichtung ein Laststrom zugeführt wird.

Das Steuergerät ist ferner dazu ausgebildet, im Anschluss an die Ermittlung des ersten Diagnosestroms ein Steuerungssignal zu erzeugen, um den Halbleiterschalter zu schalten, derart dass der vordefinierte Stromimpuls erzeugbar ist, der dem Laststrom am Laststromausgang der Halbleiterschaltereinrichtung aufprägbar ist.

Das Steuergerät ist des Weiteren dazu ausgebildet, im Anschluss an die Erzeugung des Steuerungssignals, wodurch dem Laststrom am Laststromausgang der Halbleiterschaltereinrichtung der vordefinierte Stromimpuls aufprägbar ist, einen zweiten Diagnosestrom zu ermitteln, der proportional zu der Summe des Laststroms und des vordefinierten Stromimpulses ist und von der Halbleiterschaltereinrichtung ausgegeben wird. Folglich kann ein zweiter Diagnosestrom ermittelt werden, wenn den Verbrauchern durch die Halbleiterschaltereinrichtung ein Laststrom zugeführt wird und diesem Laststrom am Laststromausgang der vordefinierte Stromimpuls aufgeprägt ist.

Das Steuergerät ist ferner dazu ausgebildet, im Anschluss an die Ermittlung des zweiten Diagnosestroms den Übertragungsfaktor unter Verwendung des ersten Diagnosestroms, des zweiten Diagnosestroms und des vordefinierten Stromimpulses zu bestimmen.

Weiterhin ist das Steuerungsgerät dazu ausgebildet, basierend auf dem ersten Diagnosestrom und dem ermittelten Übertragungsfaktor den Grenzwert zu ermitteln.

Im Anschluss an die Bestimmung des Grenzwerts kann das Steuergerät einen dritten Diagnosestrom, der proportional zu dem am Laststromausgang fließenden Strom ist und von der Halbleiterschaltereinrichtung ausgegeben wird, in Abhängigkeit des den Verbrauchern zugeführten Laststroms ermitteln. Folglich kann der dritte Diagnosestrom ermittelt werden, wenn den Verbrauchern durch die Halbleiterschaltereinrichtung ein Laststrom zugeführt wird.

Das Steuergerät kann den dritten Diagnosestrom mit dem Grenzwert und dem Diagnosestromgrenzwert vergleichen und kann in Abhängigkeit dieses Vergleichs ein Verbraucherausfallsignal ausgeben. Wenn beispielsweise der dritte Diagnosestrom niedriger ist als der ermittelte Grenzwert, erkennt das Steuergerät, dass einer der parallel geschalteten Verbraucher ausgefallen ist, und gibt ein Verbraucherausfallsignal aus. Wenn weiterhin beispielsweise bereits vor der Zufuhr eines Laststroms zu den Verbrauchern einer der Verbraucher ausgefallen ist und der Laststromgrenzwert vordefiniert ist, der repräsentativ für einen Laststrom ist, der bei einer gegebenen Anzahl von parallel geschalteten und funktionsfähigen Verbrauchern mindestens fließen muss, kann der ermittelte Laststrom mit dem vordefinierten Laststromgrenzwert verglichen werden. Wenn der Laststrom unterhalb des vordefinierten Laststromgrenzwerts liegt, kann entsprechend ein Verbraucherausfallsignal ausgegeben werden.

Bei der oben dargestellten Schaltungsanordnung kann der Halbleiterschalter ein MOSFET Transistor sein, wobei der Impulssteuerungseingang ein Gate ist und wobei der Stromeingang eine Drain ist.

Bei den oben dargestellten Schaltungsanordnungen kann das Steuergerät dazu ausgebildet sein, einige der oben beschriebenen Schritte wiederholt durchzuführen. So kann das Steuergerät dazu ausgebildet sein, wiederholt das Erzeugen des vordefinierten Stromimpulses, der dem Laststrom am Laststromausgang der Halbleiterschaltereinrichtung aufprägbar ist; das Bestimmen des Übertragungsfaktors basierend auf dem Laststrom und dem vordefinierten Stromimpuls; das Ermitteln des Grenzwerts basierend auf dem Übertragungsfaktor und dem Laststrom; und das Ausgeben des Verbraucherausfallsignals in Abhängigkeit eines Vergleichs des Diagnosestroms mit dem Grenzwert durchzuführen. Durch das wiederholende Durchführen der oben dargestellten Schritte kann eine Temperaturdrift des Übertragungsfaktors bei der Ermittlung des Grenzwerts berücksichtigt werden.

Die oben dargestellten Steuergeräte können Teil einer oder eine Karosserieelektronikeinheit (BCM) sein. Auch können die oben dargestellten Steuergeräte Teil einer Beleuchtungseinrichtung mit Leuchtmitteln, wie beispielsweise Leuchtdioden oder Glühlampen sein. Die Beleuchtungseinrichtung kann beispielsweise eine Kennzeichenbeleuchtung, ein Kraftfahrzeugscheinwerfer, eine Kraftfahrzeugheckleuchte oder eine Kraftfahrzeugbremsleuchte sein.

Bei den oben dargestellten Schaltungsanordnungen kann die Halbleiterschaltereinrichtung mit mehreren Laststromausgängen bereitgestellt sein, so dass mehrere jeweils zueinander parallel geschaltete Verbraucher von der Halbleiterschaltereinrichtung mit jeweiligen Lastströmen versorgt werden können. Bei solch einer Anordnung kann der Stromeingang des Halbleiterschalters über mehrere parallel geschaltete Widerstände mit dem Laststromausgang der Halbleiterschaltereinrichtung verbunden sein. Dabei können die jeweiligen Widerstände unterschiedliche Größen aufweisen, so dass den jeweiligen möglicherweise unterschiedlichen Lastströmen der jeweiligen Lastromausgänge entsprechend unterschiedliche Stromimpulse aufgeprägt werden können. Für die jeweiligen Laststromausgänge der Halbleiterschaltereinrichtung können unterschiedliche Grenzwerte ermittelt werden.

Gemäß einem zweiten Aspekt der vorliegenden Erfindung ist ein Verfahren zur Einzelausfallerkennung eines Verbrauchers bei parallel geschalteten Verbrauchern, die von einer Halbleiterschaltereinrichtung angesteuert werden, wobei die Halbleiterschaltereinrichtung einen Diagnosestromausgang zum Ausgeben eines Diagnosestroms umfasst, der proportional zu einem am Laststromausgang fließenden Strom ist, offenbart. Das Verfahren ist durch folgende Verfahrensschritte gekennzeichnet: Erzeugen eines vordefinierten Stromimpulses, der einem Laststrom am Laststromausgang der Halbleiterschaltereinrichtung aufgeprägt wird; Bestimmen eines Übertragungsfaktors basierend auf dem Laststrom und dem vordefinierten Stromimpuls; Ermitteln eines Grenzwerts basierend auf dem Übertragungsfaktor und dem Laststrom; Ermitteln eines Diagnosestromgrenzwerts aus einem vordefinierten Laststromgrenzwert und dem Übertragungsfaktor; und Ausgeben eines Verbraucherausfallsignals in Abhängigkeit eines Vergleichs des Diagnosestroms mit dem Grenzwert und dem Diagnosestromgrenzwert.

Zum Bestimmen des Grenzwerts kann das Verfahren ferner die folgenden Schritte umfassen: Ermitteln der Zufuhr eines Laststroms zu den Verbrauchern; Ermitteln eines ersten Diagnosestroms, der proportional zu dem Laststrom ist und von der Halbleiterschaltereinrichtung ausgegeben wird, in Abhängigkeit des den Verbrauchern zugeführten Laststroms; Erzeugen eines Steuerungssignals zum Schalten des Halbleiterschalters zum Erzeugen des vordefinierten Strompulses, der dem Laststrom am Laststromausgang der Halbleiterschaltereinrichtung aufgeprägt wird; Ermitteln eines zweiten Diagnosestroms, der proportional zu der Summe des Laststroms und des vordefinierten Stromimpulses ist und von der Halbleiterschaltereinrichtung ausgegeben wird; Bestimmen des Übertragungsfaktors unter Verwendung des ersten Diagnosestroms, des zweiten Diagnosestroms und des vordefinierten Stromimpulses; Ermitteln des Grenzwerts basierend auf dem ersten Diagnosestrom und dem Übertragungsfaktor; Ermitteln eines dritten Diagnosestroms, der proportional zu dem am Laststromausgang der Halbleiterschaltereinrichtung fließenden Stroms ist und von der Halbleiterschaltereinrichtung zugeführt wird, in Abhängigkeit des den Verbrauchern zugeführten Laststroms; Vergleichen des dritten Diagnosestroms mit dem Grenzwert und dem Diagnosestromgrenzwert; Ausgeben des Verbraucherausfallsignals in Abhängigkeit des Vergleichs des dritten Diagnosestroms mit dem Grenzwert und dem Diagnosestromgrenzwert.

Die oben dargestellten Verfahren können zum Erkennen eines Ausfalls eines Beleuchtungsmittels, so wie beispielsweise eine Leuchtdiode oder eine Glühlampe, aus einer Vielzahl von Beleuchtungsmitteln einer Beleuchtungseinrichtung genutzt werden.

## KURZE BESCHREIBUNG DER ZEICHNUNGEN

Anhand der beigefügten Zeichnungen wird die Erfindung nachfolgend näher erläutert.

Dabei zeigt

Fig. 1 schematische Verläufe von Übertragungsfaktoren (Verhältnis von Laststrom zu Diagnosestrom) in Abhängigkeit von Lastströmen am Laststromausgang einer Halbleiterschaltereinrichtung einer Schaltungsanordnung gemäß der vorliegenden Erfindung.

Fig. 2 eine Schaltungsanordnung zum Aufprägen eines Impulsstromes auf einen Laststrom zum Ermitteln eines Grenzwerts für die Einzelausfallerkennung von parallel geschalteten Verbrauchern gemäß der vorliegenden Erfindung.

Fig. 3 zeigt den zeitlichen Verlauf von Diagnoseströmen am Diagnosestromausgang einer Halbleiterschaltereinrichtung einer Schaltungsanordnung gemäß der vorliegenden Erfindung in Abhängigkeit von unterschiedlichen am Laststromausgang der Halbleiterschaltereinrichtung fließenden Strömen.

## DETAILIERTE BESCHREIBUNG VON EXEMPLARISCHEN

## AUSFÜHRUNGSFORMEN

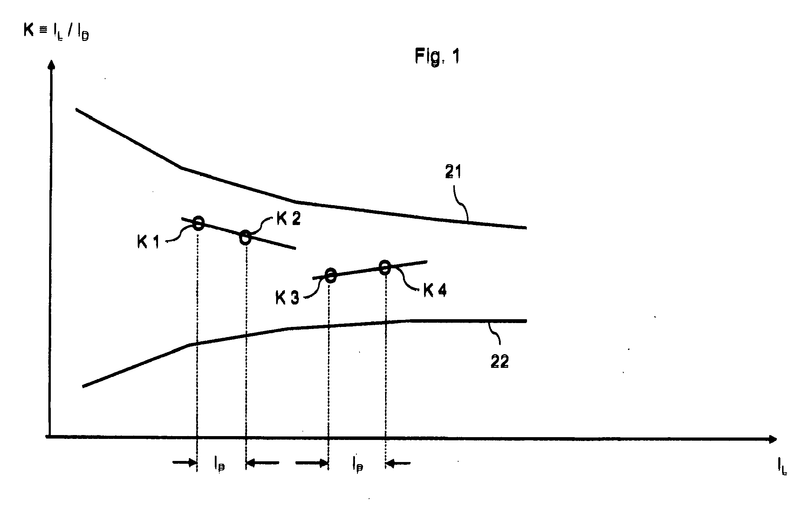

Fig. 1 zeigt schematische Verläufe von Übertragungsfaktoren K in Abhängigkeit von Lastströmen $I_L$ am Laststromausgang 12 einer Halbleiterschaltereinrichtung 10 einer Schaltungsanordnung in einem Steuergerät 100 gemäß der vorliegenden Erfindung. Dabei ist der Übertragungsfaktor K das Verhältnis des Laststroms $I_L$ am

Laststromausgang 12 der Halbleiterschaltereinrichtung 10 zu dem entsprechenden Diagnosestrom $I_D$ am Diagnosestromausgang 13 der Halbleiterschaltereinrichtung 10. Der Übertragungsfaktor ist eine Funktion des Laststroms $I_L$. Der Verlauf 21 stellt eine Entwicklung eines Übertragungsfaktors K dar, bei dem mit steigendem Laststrom $I_L$ am Laststromausgang 12 der Halbleiterschaltereinrichtung 10 das Verhältnis von Laststrom $I_L$ zu Diagnosestrom $I_D$ sinkt. Der Verlauf 22 zeigt eine Entwicklung eines Übertragungsfaktors K, bei dem mit steigendem Laststrom $I_L$ am Laststromausgang 12 der Halbleiterschaltereinrichtung 10 das Verhältnis von Laststrom $I_L$ zu Diagnosestrom $I_D$ ansteigt. Der Übertragungsfaktor K ist temperaturabhängig. Aus den Verläufen 21 und 22 ist ersichtlich, dass sich in Abhängigkeit des Übertragungsfaktorverlaufs durch Aufprägung eines Impulsstroms $I_P$ auf den Laststrom $I_L$ der Übertragungsfaktor aufgrund der fallenden oder steigenden Kennlinie von den Startpunkten der Übertragungsfaktoren K1 bzw. K3 zu den Übertragungsfaktoren K2 bzw. K4 verschieben. Dabei verändert sich aber bei typischen Impulsströmen der Übertragungsfaktor von K1 zu K2 bzw. von K3 zu K4 lediglich um 2% - 3%.

Aufgrund von Herstellungsungenauigkeit beim Herstellungsprozess der Halbleiterschaltereinrichtung 10 hat der Übertragungsfaktor K eine Herstellungstoleranz von bis zu 300 %. Für eine Einzelausfallerkennung eines Verbrauchers von parallel geschalteten Verbrauchern V1, V2 ist jedoch eine genaue Kenntnis des tatsächlichen Übertragungsfaktors K notwendig.

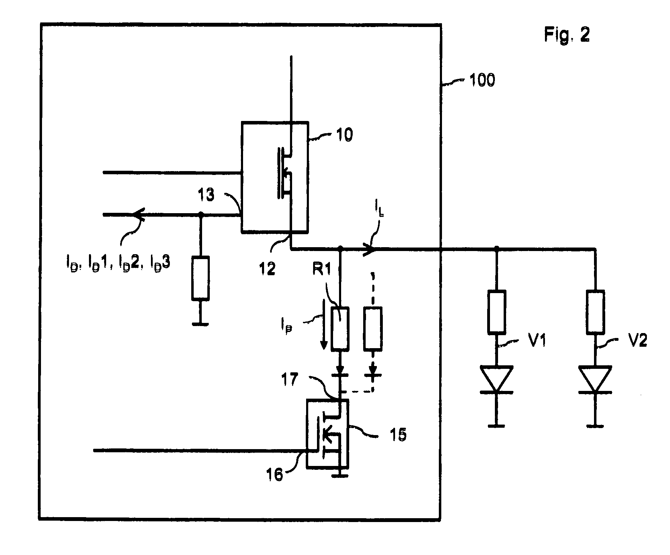

Fig. 2 zeigt eine Schaltungsanordnung zum Aufprägen eines Impulsstromes $I_P$ auf einen Laststrom $I_L$ zum Ermitteln eines Grenzwerts G für die Einzelausfallerkennung von parallel geschalteten Verbrauchern V1, V2 gemäß der vorliegenden Erfindung. Die dargestellte Schaltungsanordnung ist in einem Steuergerät 10 zur Steuerung von parallel geschalteten Verbrauchern V1, V2 untergebracht und umfasst eine Halbleiterschaltereinrichtung 10, die wiederum beispielsweise einen MOSFET Transistor umfassen kann. Die Halbleiterschaltereinrichtung 10 umfasst einen Laststromausgang 12 zum Zuführen eines Laststroms $I_L$ zu den Verbrauchern V1, V2 und umfasst ferner einen Diagnosestromausgang 13 bzw. einen Sensestromausgang 13 zum Ausgeben eines Diagnosestroms $I_D$ bzw. Sensestroms $I_D$, der proportional zu einem am Laststromausgang 12 fließenden Strom ist. Die Proportionalität zwischen dem Laststrom $I_L$ und dem Diagnosestrom $I_D$ ist durch einen Übertragungsfaktor K gegeben, der der Quotient aus Laststrom $I_L$ und Diagnosestrom $I_D$ ist. Mit bekanntem Übertragungsfaktor K kann somit der am Lastromausgang 12 der Halbleiterschaltereinrichtung 10 fließende Strom bestimmt werden durch Messen bzw. Ausgeben des Diagnosestroms $I_D$.

Das Steuergerät 100 ist ausgebildet zum Bestimmen eines Grenzwerts G für den ermittelten Laststrom $I_L$ bzw. für den detektierten Diagnosestrom $I_D$. Da der Übertragungsfaktor K aufgrund des Herstellungsprozesses eine Ungenauigkeit von bis zu 200% bis 300% aufweist, ist es zum zuverlässigen und genauen Bestimmen eines Grenzwerts G für den detektierten Laststrom $I_L$ notwendig, den Übertragungsfaktor K genügend genau zu bestimmen. Zur Bestimmung des Grenzwerts G ist das Steuergerät 100 zum Erzeugen eines vordefinierten Stromimpulses $I_P$ ausgebildet, der dem Laststrom $I_L$ am Laststromausgang 12 der Halbleiterschaltereinrichtung 10 aufgeprägt wird. Das Steuergerät 100 bestimmt anschließend den Übertragungsfaktor K basierend auf dem Laststrom $I_L$ und dem vordefinierten Stromimpuls $I_P$ und ermittelt den Grenzwert G basierend auf dem Übertragungsfaktor K und dem Laststrom $I_L$. Das Steuergerät 100 ist ferner dazu ausgebildet, basierend auf einem vordefinierten Lastromgrenzwert $I_LG$ und dem Übertragungsfaktor K einen Diagnosestromgrenzwert $I_DG$ zu ermitteln. Dieser Diagnosestromgrenzwert $I_DG$ ist der Quotient aus dem vordefinierten Laststromgrenzwert $I_LG$ und dem Übertragungsfaktor K. Der Zweck des Laststromgrenzwerts $I_LG$ bzw. des Diagnosestromgrenzwerts $I_DG$ ist dieser, dass wenn bereits vor der Zufuhr eines Laststroms $I_L$ zu den Verbrauchern V1, V2 einer der Verbraucher V1, V2 ausgefallen ist und der Laststromgrenzwert $I_LG$ vordefiniert ist, der repräsentativ für einen Laststrom $I_L$ ist, der bei einer gegebenen Anzahl von parallel geschalteten und funktionsfähigen Verbrauchern V1, V2 mindestens fließen muss, kann der ermittelte Laststrom $I_L$ mit dem vordefinierten Laststromgrenzwert $I_LG$ verglichen werden. Wenn der Laststrom $I_L$ unterhalb des vordefinierten Laststromgrenzwerts $I_LG$ liegt, kann entsprechend ein Verbraucherausfallsignal ausgegeben werden. Das Steuergerät 100 kann in Abhängigkeit eines Vergleichs des detektierten Diagnosestroms $I_D$ mit dem ermittelten Grenzwert G und dem Diagnosestromgrenzwert $I_DG$ das Verbraucherausfallsignal ausgeben.

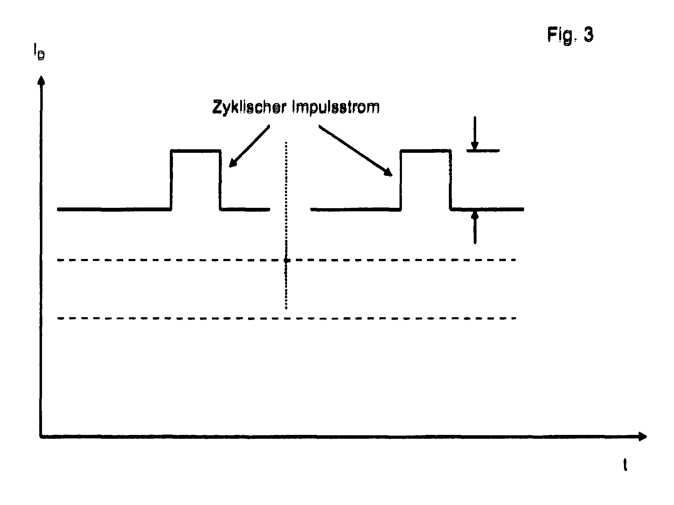

Aus den in Fig. 3 dargestellten zeitlichen Verläufen von Diagnoseströmen $I_D$ am Diagnosestromausgang 13 der Halbleiterschaltereinrichtung 10 einer Schaltungsanordnung gemäß der vorliegenden Erfindung in Abhängigkeit von unterschiedlichen am Lastromausgang 12 der Halbleiterschaltereinrichtung 10 fließenden Strömen wird das Prinzip der Einzelausfallerkennung eines Verbrauchers V1, V2 bei parallel geschalteten Verbrauchern V1, V2 erklärt. Dabei stellt in Fig. 3 die untere gestrichelte Linie einen Diagnosestrom $I_D$ dar, der proportional zu einem Laststrom $I_L$ ist, wenn lediglich ein Verbraucher V1, V2 am Laststromausgang 12 mit dem Laststrom $I_L$ versorgt wird. Die obere durchgezogene Linie stellt einen Diagnosestrom $I_D$ dar, der proportional zu einem Laststrom $I_L$ ist, wenn zwei parallel geschaltete Verbraucher V1, V2 am Laststromausgang 12 mit dem Laststrom $I_L$ versorgt werden und diesem Laststrom $I_L$ ein zyklischer bzw. ein sich regelmäßig oder unregelmäßig wiederholender Stromimpuls $I_P$ aufgeprägt ist. Folglich weist auch der diesem am Laststromausgang 12 fließenden Strom proportionale Diagnosestrom $I_D$ den gleichen Verlauf wie der Laststrom $I_L$ auf. Die mittlere gestrichelte Linie in Fig. 3 stellt einen beispielhaften Grenzwert G für den Diagnosestrom $I_D$ dar, bei dessen Unterschreitung eine Einzelausfallerkennung eines Verbrauchers bestimmt wird. Dieser Grenzwert G wird durch das Steuerungsgerät basierend auf dem vordefinierten Stromimpuls $I_P$ und dem Laststrom $I_L$ am Laststromausgang 12 bestimmt.

Die Erzeugung des dem Laststrom $I_L$ aufgeprägten Impulsstroms $I_P$ kann durch einen Halbleiterschalter 15 in dem Steuergerät 100 realisiert werden. Der in Fig. 2 dargestellte Halbleiterschalter 15 umfasst wiederum einen Impulssteuerungseingang 16 zum Empfangen eines Steuerungssignals vom Steuergerät 100, um den Halbleiterschalter 15 zu schalten. Weiterhin umfasst der Halbleiterschalter 15 einen Stromeingang 17, der mit dem Laststromausgang 12 der Halbleiterschaltereinrichtung 10 über einen Widerstand R1 verbunden ist. Durch Einschalten des Halbleiterschalters 15 durch ein Steuerungssignal vom Steuergerät 100 liegt parallel zu den Verbrauchern V1, V2 somit eine weitere, bekannte Last an. Dem am Laststromausgang 12 der Halbleiterschaltereinrichtung 10 fließenden Laststrom $I_L$ wird somit ein bekannter bzw. vordefinierter Stromimpuls $I_P$ aufgeprägt. Der Halbleiterschalter 15 kann beispielsweise ein Transistor oder ein MOSFET Transistor sein. Jedoch ist die vorliegende Erfindung nicht darauf beschränkt, dass der Stromimpuls $I_P$ durch einen Halbleiterschalter 15 erzeugt wird. Vielmehr kann der Stromimpuls $I_P$ auf jede dem Fachmann bekannte Art und Weise erzeugt und dem Laststrom $I_L$ aufgeprägt werden.

Zum Bestimmen des Grenzwerts G für den ermittelten Diagnosestrom $I_D$, der proportional zu dem Laststrom $I_L$ am Laststromausgang 12 der Halbleiterschaltereinrichtung 10 ist, kann das Steuergerät 100 ferner eine Zufuhr eines Laststroms $I_L$ zu den Verbrauchern V1, V2 ermitteln. Das Steuergerät 100 ermittelt folglich, ob den Verbrauchern V1, V2 durch die Halbleiterschaltereinrichtung 10 ein Laststrom $I_L$ zugeführt wird. Das Steuergerät 100 ermittelt im Anschluss einen ersten Diagnosestrom $I_D1$, der proportional zu dem Laststrom $I_L$ ist und von der Halbleiterschaltereinrichtung 10 ausgegeben wird, in Abhängigkeit des den Verbrauchern V1, V2 zugeführten Laststroms $I_L$. Folglich wird ein erster Diagnosestrom $I_D1$ ermittelt, wenn den Verbrauchern V1, V2 durch die Halbleiterschaltereinrichtung 10 ein Laststrom $I_L$ zugeführt wird. Im Anschluss an die Ermittlung des ersten Diagnosestroms $I_D1$ erzeugt das Steuergerät 100 ein Steuerungssignal zum Schalten des Halbleiterschalters 15, so dass der vordefinierte Stromimpuls $I_P$ erzeugt wird, der dem Laststrom $I_L$ am Laststromausgang 12 der Halbleiterschaltereinrichtung 10 aufgeprägt wird. Im Anschluss daran ermittelt das Steuergerät 10 einen zweiten Diagnosestrom $I_D2$, der proportional zu der Summe des Laststroms $I_L$ und des vordefinierten Stromimpulses $I_P$ ist und von der Halbleiterschaltereinrichtung 10 ausgegeben wird. Folglich wird ein zweiter Diagnosestrom $I_D2$ ermittelt, wenn den Verbrauchern V1, V2 durch die Halbleiterschaltereinrichtung 10 ein Laststrom $I_L$ zugeführt wird und diesem Laststrom $I_L$ am Laststromausgang 12 der vordefinierte Stromimpuls $I_P$ aufgeprägt ist. Im Anschluss an die Ermittlung des zweiten Diagnosestroms $I_D2$ wird der Übertragungsfaktor K bestimmt, unter Verwendung des ersten Diagnosestroms $I_D1$, des zweiten Diagnosestroms $I_D2$ und des vordefinierten Stromimpulses $I_P$.

Bei dieser Bestimmung des Übertragungsfaktors K wird angenommen, dass der Übertragungsfaktor K für die Halbleiterschaltereinrichtung 10 annähernd unabhängig von dem aufgeprägten Impulsstrom $I_P$ ist. Diese Annahme ist berechtigt, da wie oben beschrieben durch eine Aufprägung eines Impulsstromes $I_P$ auf einen Laststrom $I_L$ der Übertragungsfaktor sich lediglich um 2% bis 3% verändert.

Dabei ergibt sich der Übertragungsfaktor K gemäß dem Ausdruck

$$K = \frac{I_P}{I_D2 - I_D1}$$

Das Steuerungsgerät 100 ermittelt basierend auf dem ersten Diagnosestrom $I_D1$ und dem ermittelten Übertragungsfaktor K den Grenzwert G. Im Anschluss an die Bestimmung des Grenzwerts G ermittelt das Steuergerät 100 einen dritten Diagnosestrom $I_D3$, der proportional zu dem am Laststromausgang 12 fließenden Strom ist und von der Halbleiterschaltereinrichtung 10 ausgegeben wird, wenn den Verbrauchern V1, V2 durch die Halbleiterschaltereinrichtung 10 ein Laststrom $I_L$ zugeführt wird. Das Steuergerät 100 vergleicht den dritten Diagnosestrom $I_D3$ mit dem Grenzwert G und dem Diagnosestromgrenzwert $I_DG$ und gibt in Abhängigkeit dieses Vergleichs ein Verbraucherausfallsignal aus. Wenn beispielsweise der dritte Diagnosestrom $I_D3$ niedriger als der ermittelte Grenzwert G oder der berechnete Diagnosestromgrenzwert $I_DG$ ist, erkennt das Steuergerät 100, dass einer der parallel geschalteten Verbraucher V1, V2 ausgefallen ist, und gibt ein Verbraucherausfallsignal aus.

In den oben dargestellten Ausführungen wurden zwei parallel angeordnete Verbraucher V1, V2 zum Erklären der vorliegenden Erfindung und deren Funktionsweise verwendet. Jedoch ist die vorliegende Erfindung nicht auf eine Einzelausfallerkennung von zwei Verbrauchern beschränkt. Vielmehr kann auch bei drei und mehr parallel geschalteten Verbrauchern mittels der Schaltungsanordnung gemäß der vorliegenden Erfindung der Ausfall eines dieser Verbraucher V1, V2 erkannt werden. Die in den oben dargestellten Ausführungen beschriebenen Verbraucher V1, V2 können beispielsweise Leuchtmittel, insbesondere Leuchtdioden (LED's) oder Glühlampen einer Beleuchtungseinrichtung wie beispielsweise einer Kennzeichenbeleuchtung, eines Kraftfahrzeugscheinwerfers, einer Kraftfahrzeugheckleuchte oder einer Kraftfahrzeugbremsleuchte sein.

Bezugszeichenliste

| | |
|---|---|
| 10 | Halbleiterschaltereinrichtung |
| 12 | Laststromausgang |
| 13 | Diagnosestromausgang |
| 15 | Halbleiterschalter |
| 16 | Impulssteuerungseingang |
| 17 | Stromeingang |
| 21 | Entwicklung des Übertragungsfaktors |
| 22 | Entwicklung des Übertragungsfaktors |
| 100 | Steuergerät |
| | |
| V1, V2 | Verbraucher |
| $I_L$ | Laststrom |
| $I_D$ | Diagnosestrom |
| $I_P$ | Stromimpuls |
| K | Übertragungsfaktor |
| R1 | Widerstand |
| $I_L$ | Laststrom |
| $I_D1$ | erster Diagnosestrom |
| $I_D2$ | zweiter Diagnosestrom |
| $I_D3$ | dritter Diagnosestrom |
| G | Grenzwert |

**Patentansprüche**

1. Steuergerät (100) zur Steuerung von parallel geschalteten Verbrauchern (V1, V2), das Steuergerät (100) umfassend eine Schaltungsanordnung, die Schaltungsanordnung umfassend eine Halbleiterschaltereinrichtung (10), umfassend einen Laststromausgang (12) zum Zuführen eines Laststroms ($I_L$) zu den Verbrauchern (V1, V2), und einen Diagnosestromausgang (13) zum Ausgeben eines Diagnosestroms ($I_D$, $I_D1$, $I_D2$, $I_D3$), der proportional zu einem am Laststromausgang (12) fließenden Strom ist; **dadurch gekennzeichnet, dass** das Steuergerät (100) ausgebildet ist zum

**EP 2 390 678 B1**

- Erzeugen eines vordefinierten Stromimpulses ($I_P$), der dem Laststrom ($I_L$) am Laststromausgang (12) aufprägbar ist;
- Bestimmen eines Übertragungsfaktors (K) basierend auf dem Laststrom ($I_L$) und dem vordefinierten Stromimpuls ($I_P$);
- Ermitteln eines Grenzwerts (G) basierend auf dem Übertragungsfaktor (K) und dem Laststrom ($I_L$);
- Ermitteln eines Diagnosestromgrenzwerts ($I_D G$) aus einem vordefinierten Laststromgrenzwert ($I_L G$) und dem Übertragungsfaktor (K);
- Ausgeben eines Verbraucherausfallsignals in Abhängigkeit eines Vergleichs des Diagnosestroms ($I_D$) mit dem Grenzwert (G) und dem Diagnosestromgrenzwert ($I_D G$).

2.  Steuergerät (100) nach Anspruch 1, ferner umfassend einen Halbleiterschalter (15), umfassend einen Impulssteuerungseingang (16) zum Empfangen eines Steuerungssignals vom Steuergerät (100) zum Schalten des Halbleiterschalters (15), und einen Stromeingang (17), der mit dem Laststromausgang (12) der Halbleiterschaltereinrichtung (10) über einen Widerstand (R1) verbunden ist, wobei durch Schalten des Halbleiterschalters (15) der vordefinierte Stromimpuls ($I_P$) dem Laststrom ($I_L$) am Laststromausgang (12) der Halbleiterschaltereinrichtung (10) aufprägbar ist.

3.  Steuergerät (100) nach Anspruch 2, **dadurch gekennzeichnet, dass** das Steuergerät (100) ausgebildet ist zum

- Ermitteln der Zufuhr eines Laststroms ($I_L$) zu den Verbrauchern (V1, V2);
- Ermitteln eines ersten Diagnosestroms ($I_D 1$), der proportional zu dem Laststrom ($I_L$) ist und von der Halbleiterschaltereinrichtung (10) ausgebbar ist, in Abhängigkeit des den Verbrauchern (V1, V2) zugeführten Laststroms ($I_L$);
- Erzeugen eines Steuerungssignals zum Schalten des Halbleiterschalters (15) zum Erzeugen des vordefinierten Strompulses ($I_P$), der dem Laststrom ($I_L$) am Laststromausgang (12) der Halbleiterschaltereinrichtung (10) aufprägbar ist;
- Ermitteln eines zweiten Diagnosestroms ($I_D 2$), der proportional zu der Summe des Laststroms ($I_L$) und des vordefinierten Stromimpulses ($I_P$) ist und von der Halbleiterschaltereinrichtung (10) ausgebbar ist;
- Bestimmen des Übertragungsfaktors (K) unter Verwendung des ersten Diagnosestroms ($I_D 1$), des zweiten Diagnosestroms ($I_D 2$) und des vordefinierten Stromimpulses ($I_P$);
- Ermitteln des Grenzwerts (G) basierend auf dem ersten Diagnosestrom ($I_D 1$) und dem Übertragungsfaktor (K);
- Ermitteln eines dritten Diagnosestroms ($I_D 3$), der proportional zu dem am Laststromausgang (12) der Halbleiterschaltereinrichtung (10) fließenden Stroms ist und von der Halbleiterschaltereinrichtung (10) zuführbar ist, in Abhängigkeit des den Verbrauchern (V1, V2) zugeführten Laststroms ($I_L$);
- Vergleichen des dritten Diagnosestroms ($I_D 3$) mit dem Grenzwert (G) und dem Diagnosestromgrenzwert ($I_D G$);
- Ausgeben des Verbraucherausfallsignals in Abhängigkeit des Vergleichs des dritten Diagnosestroms ($I_D 3$) mit dem Grenzwert (G) und dem Diagnosestromgrenzwert ($I_D G$).

4.  Steuergerät (100) nach Anspruch 2 oder 3, **dadurch gekennzeichnet, dass** der Halbleiterschalter (15) ein MOSFET Transistor ist und der Impulssteuerungseingang (16) ein Gate ist und der Stromeingang (17) eine Drain ist.

5.  Steuergerät (100) nach einem der vorhergehenden Ansprüche 1 bis 4, **dadurch gekennzeichnet, dass** das Steuergerät (100) ausgebildet ist zum wiederholenden Durchführen des

- Erzeugens des vordefinierten Stromimpulses ($I_P$), der dem Laststrom ($I_L$) am Laststromausgang (12) der Halbleiterschaltereinrichtung (10) aufprägbar ist;
- Bestimmens des Übertragungsfaktors (K) basierend auf dem Laststrom ($I_L$) und dem vordefinierten Stromimpuls ($I_P$);
- Ermittelns des Grenzwerts (G) basierend auf dem Übertragungsfaktor (K) und dem Laststrom ($I_L$);
- Ausgebens des Verbraucherausfallsignals in Abhängigkeit eines Vergleichs des Diagnosestroms ($I_D$) mit dem Grenzwert (G).

6.  Steuergerät (100) nach einem der vorhergehenden Ansprüche 1 bis 5, **dadurch gekennzeichnet, dass** das Steuergerät (100) Teil einer oder eine Karosserieelektronikeinheit ist.

7.  Steuergerät (100) nach einem der vorhergehenden Ansprüche 1 bis 6, **dadurch gekennzeichnet, dass** die Verbraucher (V1, V2) Leuchtdioden oder Glühlampen sind.

8.  Verfahren zur Einzelausfallerkennung eines Verbrauchers (V1, V2) bei parallel geschalteten Verbrauchern (V1, V2),

8

die von einer Halbleiterschaltereinrichtung (10) angesteuert werden, wobei die Halbleiterschaltereinrichtung (10) einen Diagnosestromausgang (13) zum Ausgeben eines Diagnosestroms ($I_D$, $I_D1$, $I_D2$, $I_D3$) umfasst, der proportional zu einem am Laststromausgang (12) fließenden Strom ist, umfassend die folgenden Schritte:

- Erzeugen eines vordefinierten Stromimpulses ($I_P$), der einem Laststrom ($I_L$) am Laststromausgang (12) der Halbleiterschaltereinrichtung (10) aufgeprägt wird;
- Bestimmen eines Übertragungsfaktors (K) basierend auf dem Laststrom ($I_L$) und dem vordefinierten Stromimpuls ($I_P$);
- Ermitteln eines Grenzwerts (G) basierend auf dem Übertragungsfaktor (K) und dem Laststrom ($I_L$);
- Ermitteln eines Diagnosestromgrenzwerts ($I_DG$) aus einem vordefinierten Laststromgrenzwert ($I_LG$) und dem Übertragungsfaktor (K);
- Ausgeben eines Verbraucherausfallsignals in Abhängigkeit eines Vergleichs des Diagnosestroms ($I_D$) mit dem Grenzwert (G) und dem Diagnosestromgrenzwert ($I_DG$).

9.  Verfahren nach Anspruch 8, ferner umfassend die folgenden Schritte:

- Ermitteln der Zufuhr eines Laststroms ($I_L$) zu den Verbrauchern (V1, V2);
- Ermitteln eines ersten Diagnosestroms ($I_D1$). der proportional zu dem Laststrom ($I_L$) ist und von der Halbleiterschaltereinrichtung (10) ausgegeben wird, in Abhängigkeit des den Verbrauchern (V1, V2) zugeführten Laststroms ($I_L$):
- Erzeugen eines Steuerungssignals zum Schalten des Halbleiterschalters (15) zum Erzeugen des vordefinierten Stromimpulses ($I_P$), der dem Laststrom ($I_L$) am Laststromausgang (12) der Halbleiterschaltereinrichtung (10) aufgeprägt wird;
- Ermitteln eines zweiten Diagnosestroms ($I_D2$), der proportional zu der Summe des Laststroms ($I_L$) und des vordefinierten Stromimpulses ($I_P$) ist und von der Halbleiterschaltereinrichtung (10) ausgegeben wird;
- Bestimmen des Übertragungsfaktors (K) unter Verwendung des ersten Diagnosestroms ($I_P1$), des zweiten Diagnosestroms ($I_D2$) und des vordefinierten Stromimpulses ($I_P$);
- Ermitteln des Grenzwerts (G) basierend auf dem ersten Diagnosestrom ($I_P1$) und dem Übertragungsfaktor (K);
- Ermitteln eines dritten Diagnosestroms ($I_P3$), der proportional zu dem am Laststromausgang (12) der Halbleiterschaltereinrichtung (10) fließenden Stroms ist und von der Halbleiterschaltereinrichtung (10) zugeführt wird, in Abhängigkeit des den Verbrauchern (V1, V2) zugeführten Laststroms ($I_L$);
- Vergleichen des dritten Diagnosestroms ($I_D3$) mit dem Grenzwert (G) und dem Diagnosestromgrenzwert ($I_DG$);
- Ausgeben des Verbraucherausfallsignals in Abhängigkeit des Vergleichs des dritten Diagnosestroms ($I_D3$) mit dem Grenzwert (G) und dem Diagnosestromgrenzwert ($I_DG$).

10. Das Verfahren nach Anspruch 8 oder 9, wobei die Verbraucher (V1, V2) Leuchtdioden oder Glühlampen sind.

**Claims**

1.  Control unit (100) for the control of consumers (V1, V2) switched in parallel, the control unit (100) comprising a circuit arrangement, the circuit arrangement comprising a semiconductor switch device (10), comprising a load current output (12) for the feeding of a load current ($I_L$) to the consumers (V1, V2), and a diagnosis current output (13) for the provision of a diagnosis current ($I_D$, $I_D1$, $I_D2$, $I_D3$) being proportional to a current flowing at the load current output (12);
    **characterized in that** the control unit (100) is designed for

    - The generation of a predefined current pulse ($I_P$)addible to the load current ($I_L$) at the load current output (12);
    - The determination of a transmission factor (K) based on the load current ($I_L$) and the predefined current pulse ($I_P$);
    - The identification of a limit value (G) based on the transmission factor (K) and the load current ($I_L$);
    - The identification of a diagnosis current limit value ($I_DG$) from a predefined load current limit value ($I_LG$) and the transmission factor (K);
    - The emission of a consumer failure signal depending on a comparison of the diagnosis current ($I_D$) with the limit value (G) and the diagnosis current limit value ($I_DG$).

2.  Control unit (100) according to Claim 1, further comprising a semiconductor switch (15), comprising a pulse control input (16) for the reception of a control signal from the control unit (100) for the switching of the semiconductor switch (15), and a current input (17) being connected to the load current output (12) of the semiconductor switch device (10) by means of a resistor (R1), wherein the predefined current pulse ($I_P$) can be added to the load current ($I_L$) at the load current output (12) of the semiconductor switch device (10) by switching the semiconductor switch (15).

3. Control unit (100) according to Claim 2, **characterized in that** the control unit (100) is designed for the

- Determination of the supply of a load current ($I_L$) to the consumers (V1, V2);
- Determination of a first diagnosis current ($I_D1$) being proportional to the load current ($I_L$) and being emittable by the semiconductor switch device (10), as a function of the load current ($I_L$) supplied to the consumers (V1, V2);
- Generation of a control signal for the switching of the semiconductor switch (15) for the generation of the predefined current pulse ($I_P$) addible to the load current ($I_L$) at the load current output (12) of the semiconductor switch device (10);
- Determination of a second diagnosis current ($I_D2$) being proportional to the sum of the load current ($I_L$) and the predefined current pulse ($I_P$) and which is emittable by the semiconductor switch device (10);
- Determination of the transmission factor (K) using the first diagnosis current ($I_DI$), the second diagnosis current ($I_D2$) and the predefined current pulse ($I_P$);
- Determination of the limit value (G) on the basis of the first diagnosis current ($I_{D1}$) and the transmission factor (K);
- Determination of a third diagnosis current ($I_D3$) being proportional to the current flowing at the load current output (12) of the semiconductor switch device (10) and being suppliable by the semiconductor switch device (10), as a factor of the load current ($I_L$) supplied to the consumers (V1, V2);
- Comparison of the third diagnosis current ($I_D3$) with the limit value (G) and the diagnosis current limit value ($I_DG$);
- Emission of the consumer failure signal as a factor of the comparison of the third diagnosis current ($I_D3$) with the limit value (G) and the diagnosis current limit value ($I_{DG}$).

4. Control unit (100) according to Claim 2 or 3, **characterized in that** the semiconductor switch (15) is a MOSFET transistor and the pulse control input (16) is a gate and the current input (17) is a drain.

5. Control unit (100) according to one of the previous Claims 1 to 4, **characterized in that** the control unit (100) is designed for the repeated execution of the

- Generation of the predefined current pulse ($I_P$), which is addible to the load current ($I_L$) at the load current output (12) of the semiconductor switch device (10);
- Determination of the transmission factor (K) based on the load current ($I_L$) and the predefined current pulse ($I_P$);
- Identification of the limit value (G) based on the transmission factor (K) and the load current ($I_L$);
- Emission of the consumer failure signal as a factor of the comparison of the diagnosis current ($I_D$) with the limit value (G).

6. Control unit (100) according to one of the previous Claims 1 to 5, **characterized in that** the control unit (100) is a body electronic unit or part of a body electronics unit.

7. Control unit (100) according to one of the previous Claims 1 to 6, **characterized in that** the consumers (V1, V2) are light emitting diodes or incandescent lamps.

8. Procedure for the individual failure identification of a consumer (V1, V2) with consumers (V1, V2) switched in parallel and being controlled by a semiconductor switch device (10), wherein the semiconductor switch device (10) has a diagnosis current output (13) for the emission of a diagnosis current ($I_D$, $I_D1$, $I_D2$, $I_D3$) being proportional to a current flowing at the load current output (12), comprising the following steps:

- Generation of a predefined current pulse ($I_P$) being added to a load current ($I_L$) at the load current output (12) of the semiconductor switch device (10);
- Determination of a transmission factor (K) based on the load current ($I_L$) and the predefined current pulse ($I_P$);
- Identification of a limit value (G) based on the transmission factor (K) and the load current ($I_L$);
- Identification of a diagnosis current limit value ($I_DG$) from a predefined load current limit value ($I_LG$) and the transmission factor (K);
- Emission of a consumer failure signal as a factor of the comparison of the diagnosis current ($I_D$) with the limit value (G) and the diagnosis current limit value ($I_DG$).

9. Procedure according to Claim 8, furthermore comprising the following steps:

- Determination of the supply of a load current ($I_L$) to the consumers (V1, V2);
- Determination of a first diagnosis current ($I_D1$) being proportional to the load current ($I_L$) and being emitted by the semiconductor switch device (10), as a function of the load current ($I_L$) supplied to the consumers (V1, V2);
- Generation of a control signal for the switching of the semiconductor switch (15) for the generation of the predefined current pulse ($I_P$) which is added to the load current ($I_L$) at the load current output (12) of the semiconductor switch device (10);
- Determination of a second diagnosis current ($I_P2$) being proportional to the sum of the load current ($I_L$) and the predefined current pulse ($I_P$) and being emitted by the semiconductor switch device (10);
- Determination of the transmission factor (K) using the first diagnosis current ($I_{D1}$), the second diagnosis current ($I_D2$) and the predefined current pulse ($I_P$);
- Determination of the limit value (G) on the basis of the first diagnosis current ($I_D1$) and the transmission factor (K);
- Determination of a third diagnosis current ($I_D3$) being proportional to the current flowing at the load current output (12) of the semiconductor switch device (10) and being supplied by the semiconductor switch device (10), as a factor of the load current ($I_L$) supplied to the consumers (V1, V2);
- Comparison of the third diagnosis current ($I_D3$) with the limit value (G) and the diagnosis current limit value ($I_DG$);
- Emission of the consumer failure signal as a factor of the comparison of the third diagnosis current ($I_D3$) with the limit value (G) and the diagnosis current limit value ($I_DG$).

**10.** The procedure according to Claim 8 or 9, wherein the consumers (V1, V2) are light emitting diodes or incandescent lamps.

## Revendications

**1.** Boîtier électronique (100) pour commander des consommateurs mis en parallèle (V1, V2), le boîtier électronique (100) comprenant un agencement de commutation, l'agencement de commutation comprenant un dispositif à commutateur semi-conducteur (10), comprenant une sortie de courant de charge (12) pour conduire un courant de charge ($I_L$) aux consommateurs (V1, V2),
et une sortie de courant diagnostic (13) pour émettre un courant diagnostic (**$I_D$,** $I_D1$, $I_D2$, $I_D3$) qui est proportionnel à un courant conduit à la sortie du courant de charge (12),
**caractérisé en ce que**
le boîtier électronique (100) est réalisé de manière à

- produire une impulsion de courant ($I_P$) prédéfinie qui peut être ajoutée au courant de charge ($I_L$) à la sortie du courant de charge (12).
- déterminer un facteur de transfert (K) basant sur le courant de charge ($I_L$) et l'impulsion de courant ($I_P$) prédéfinie,
- déterminer une valeur limite (G) basant sur le facteur de transfert (K) et le courant de charge ($I_L$),
- déterminer une valeur limite de courant diagnostic ($I_DG$) d'une valeur limite de courant de charge ($I_LG$) prédéfinie et du facteur de transfert (K),
- émettre un signal de défaillance de consommateur en fonction d'une comparaison du courant diagnostic ($I_D$) avec la valeur limite (G) et la valeur limite de courant diagnostic ($I_DG$).

**2.** Boîtier électronique (100) selon la revendication 1, comprenant de plus un commutateur semi-conducteur (15), comprenant une entrée de commande à impulsion (16) pour recevoir un signal de commande du boîtier électronique (100) pour commuter le commutateur semi-conducteur (15) et une entrée de courant (17) qui est reliée à la sortie du courant de charge (12) du dispositif à commutateur semi-conducteur (10) au moyen d'une résistance (R1), l'impulsion de courant ($I_P$) prédéfinie étant ajoutable au courant de charge ($I_L$) à la sortie du courant de charge (12) du dispositif à commutateur semi-conducteur (10) par la commutation du commutateur semi-conducteur (15).

**3.** Boîtier électronique (100) selon la revendication 2, **caractérisé en ce que**
le boîtier électronique (100) est réalisé de manière à

- déterminer la conduite d'un courant de charge ($I_L$) aux consommateurs (V1, V2),
- déterminer un premier courant diagnostic ($I_D1$ qui est proportionnel au courant de charge ($I_L$) et qui peut être émis par le dispositif à commutateur semi-conducteur (10), en fonction du courant de charge ($I_L$) conduit aux consommateurs (V1, V2),
- produire un signal de commande pour commuter le commutateur semi-conducteur (15) pour produire l'impulsion de courant ($I_P$) prédéfinie qui peut être ajoutée au courant de charge ($I_L$) à la sortie du courant de charge (12) du dispositif à commutateur semi-conducteur (10),

- déterminer un deuxième courant diagnostic ($I_D2$) qui est proportionnel à la somme du courant de charge ($I_L$) et à l'impulsion de courant ($I_P$) prédéfinie et qui peut être émis par le dispositif à commutateur semi-conducteur (10),

- déterminer le facteur de transfert (K) en appliquant le premier courant diagnostic ($I_D1$), le deuxième courant diagnostic ($I_D2$) et l'impulsion de courant ($I_P$) prédéfinie,

- déterminer la valeur limite (G) basant sur le premier courant diagnostic ($I_D1$) et le facteur de transfert (K),

- déterminer un troisième courant diagnostic ($I_D3$) qui est proportionnel au courant conduit à la sortie du courant de charge (12) du dispositif à commutateur semi-conducteur (10) et qui peut être conduit du dispositif à commutateur semi-conducteur (10) en fonction du courant de charge ($I_L$) conduit aux consommateurs (V1, V2),

- comparer le troisième courant diagnostic ($I_D3$) avec la valeur limite (G) et la valeur limite de courant diagnostic ($I_DG$).

- émettre un signal de défaillance de consommateur en fonction de la comparaison du troisième courant diagnostic ($I_D3$) avec la valeur limite (G) et la valeur limite de courant diagnostic ($I_DG$).

4.  Boîtier électronique (100) selon la revendication 2 ou 3, **caractérisé en ce que** le commutateur semi-conducteur (15) est un transistor MOSFET et l'entrée de commande à impulsion (16) est une porte (gate) et l'entrée de courant (17) est un drain.

5.  Boîtier électronique (100) selon l'une des revendications 1 à 4, **caractérisé en ce que** le boîtier électronique (100) est réalisé pour exercer de manière répétée

    - la production de l'impulsion de courant ($I_P$) prédéfinie qui peut être ajoutée au courant de charge ($I_L$) à la sortie du courant de charge (12) du dispositif à commutateur semi-conducteur (10),
    - la détermination du facteur de transfert (K) basant sur le courant de charge ($I_L$) et l'impulsion de courant ($I_P$) prédéfinie,
    - la détermination de la valeur limite (G) basant sur le facteur de transfert (K) et le courant de charge ($I_L$),
    - l'émission du signal de défaillance de consommateur en fonction d'une comparaison du courant diagnostic ($I_D$) avec la valeur limite (G).

6.  Boîtier électronique (100) selon l'une des revendications 1 à 5, **caractérisé en ce que** le boîtier électronique (100) fait partie ou est une unité de l'électronique de carrosserie.

7.  Boîtier électronique (100) selon l'une des revendications 1 à 6, **caractérisé en ce que** les consommateurs (V1, V2) sont des diodes électroluminescentes ou des lampes.

8.  Procédé de détection de la défaillance individuelle d'un consommateur (V1, V2) en cas de consommateurs montés en parallèle (V1, V2) qui sont commandés par un dispositif à commutateur semi-conducteur (10), le dispositif à commutateur semi-conducteur (10) comprenant une sortie de courant diagnostic (13) pour émettre un courant diagnostic ($I_D$, $I_D1$, **$I_D2$**, $I_D3$) qui est proportionnel à un courant conduit à la sortie du courant de charge (12), comprenant les étapes suivantes :

    - produire une impulsion de courant ($I_P$) prédéfinie qui est ajoutée au courant de charge ($I_L$) à la sortie du courant de charge (12) du dispositif semi-conducteur (10),
    - déterminer un facteur de transfert (K) basant sur le courant de charge ($I_L$) et l'impulsion de courant ($I_P$) prédéfinie,
    - déterminer une valeur limite (G) basant sur le facteur de transfert (K) et le courant de charge ($I_L$),
    - déterminer une valeur limite de courant diagnostic ($I_DG$) d'une valeur limite de courant de charge ($I_LG$) prédéfinie et du facteur de transfert (K),
    - émettre un signal de défaillance de consommateur en fonction d'une comparaison du courant diagnostic ($I_D$) avec la valeur limite (G) et la valeur limite de courant diagnostic ($I_DG$).

9.  Procédé selon la revendication 8, comprenant de plus les étapes suivantes :

    - déterminer la conduite d'un courant de charge ($I_L$) aux consommateurs (V1, V2),
    - déterminer un premier courant diagnostic ($I_D1$ qui est proportionnel au courant de charge ($I_L$) et qui est émis par le dispositif à commutateur semi-conducteur (10), en fonction du courant de charge ($I_L$) conduit aux consommateurs (V1, V2),
    - produire un signal de commande pour commuter le commutateur semi-conducteur (15) pour produire l'impulsion de courant ($I_P$) prédéfinie qui est ajoutée au courant de charge ($I_L$) à la sortie du courant de charge (12) du dispositif à commutateur semi-conducteur (10),

- déterminer un deuxième courant diagnostic ($I_D2$) qui est proportionnel à la somme du courant de charge ($I_L$) et à l'impulsion de courant ($I_P$) prédéfinie et qui est émis par le dispositif à commutateur semi-conducteur (10),

- déterminer le facteur de transfert (K) en appliquant le premier courant diagnostic ($I_D1$), le deuxième courant diagnostic ($I_D2$) et l'impulsion de courant ($I_P$) prédéfinie,

- déterminer la valeur limite (G) basant sur le premier courant diagnostic ($I_D1$) et le facteur de transfert (K),

- déterminer un troisième courant diagnostic ($I_D3$) qui est proportionnel au courant conduit à la sortie du courant de charge (12) du dispositif à commutateur semi-conducteur (10) et qui est conduit par le dispositif à commutateur semi-conducteur (10) en fonction du courant de charge ($I_L$) conduit aux consommateurs (V1, V2),

- comparer le troisième courant diagnostic ($I_D3$) avec la valeur limite (G) et la valeur limite de courant diagnostic ($I_DG$).

- émettre un signal de défaillance de consommateur en fonction de la comparaison du troisième courant diagnostic ($I_D3$) avec la valeur limite (G) et la valeur limite de courant diagnostic ($I_DG$).

**10.** Procédé selon la revendication 8 ou 9, les consommateurs (V1, V2) étant des diodes électroluminescentes ou des lampes.

Fig. 1

$K \equiv I_L / I_D$

21

K 1

K 2

K 3

K 4

22

$I_B$

$I_B$

$I_L$

EP 2 390 678 B1

Fig. 2

Fig. 3

Zyklischer Impulsstrom

**EP 2 390 678 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7363186 B1
- DE 202007007776 U1